# EUROPÄISCHE PATENTANMELDUNG

(11) **EP 1 696 497 A1**
(43) Veröffentlichungstag der Anmeldung: **30.08.2006**
(21) Anmeldenummer: 06100018.8
(22) Anmeldetag: 02.01.2006
(51) Int. Cl.: H01L 41/053

(54) **Aktormodul mit einem Piezoaktor**

(30) Priorität: 25.02.2005 DE 102005008717
(71) Anmelder: ROBERT BOSCH GMBH, 70442 Stuttgart (DE)
(72) Erfinder: Rapp, Holger, 71254, Ditzingen (DE); Sutter, Kai, 70372, Stuttgart (DE); Schwarz, Thomas, 73614, Schorndorf (DE)

(57) **Zusammenfassung**

Es wird ein Aktormodul mit einem in einer Hülse (9) angeordneten Piezoaktor (1) vorgeschlagen, wobei der Piezoaktor (1) zwischen einem Aktorfuß (10) und einem Aktorkopf (11) eingefasst ist. Der Aktorfuß (10) und/oder der Aktorkopf (11) sind aus einem Sintermaterial (20) hergestellt und gegebenenfalls mit Durchgangsbohrungen (21,22) zur besseren Dämpfung des Schwingungsverhaltens versehen.

## Beschreibung

### Stand der Technik

Die Erfindung betrifft ein Aktormodul mit einem Piezoaktor der über ein Kopf- und Fußteil in einem Gehäuse oder einer Hülse liegt, beispielsweise zur Betätigung eines mechanischen Bauteils wie ein Ventil oder dergleichen, nach den gattungsgemäßen Merkmalen des Hauptanspruchs.

Es ist allgemein bekannt, dass unter Ausnutzung des sogenannten Piezoeffekts ein Piezoelement aus einem Material mit einer geeigneten Kristallstruktur aufgebaut werden kann. Bei Anlage einer äußeren elektrischen Spannung erfolgt eine mechanische Reaktion des Piezoelements, die in Abhängigkeit von der Kristallstruktur und der Anlagebereiche der elektrischen Spannung einen Druck oder Zug in eine vorgebbare Richtung darstellt. Solche piezoelektrischen Aktoren eignen sich insbesondere für den Einsatz bei schnellen und präzisen Schaltvorgängen, beispielsweise in verschiedenen Systemen für eine Benzin- oder Dieseleinspritzung in Verbrennungsmotoren.

Der Aufbau dieses Piezoaktors kann hier in mehreren Schichten erfolgen (Multilayer-Aktoren), wobei die Elektroden, über die die elektrische Spannung aufgebracht wird, jeweils zwischen den Schichten angeordnet werden. Beispielsweise ist ein solcher Piezoaktor aus der DE 199 28 177 A1 bekannt.

Insbesondere bei heute üblichen Piezoaktoren für sogenannte Common-Rail-Injektoren für Dieselmotoren ist der Piezoaktor in ein sogenanntes Aktormodul eingebaut. Dieses Aktormodul besteht aus dem Piezoaktor selbst mit einem Aktorkopf, der die Aktorkraft an das zu betätigende Bauteil weitergibt und einem Aktorfuß, über den sich der Piezoaktor im Injektorkörper abstützt. Diese Anordnung sitzt in einer Hülse, die mit dem Aktorfuß dicht verschweißt ist und es ist in der Regel ein bewegliches Dichtelement vorhanden, welches den Aktorkopf und die Hülse dicht, aber gegeneinander verschiebbar verbindet.

Der zuvor erwähnten Aktorfuß hat im wesentlichen die Aufgabe, den Innenraum des Aktormoduls gegen den elektrischen Anschluss des Injektors abzudichten, was beispielsweise durch einen O-Ring erfolgen kann, sowie die elektrische Kontaktierung des Piezoaktors überhaupt zu ermöglichen. Ferner ist der Zwischenraum zwischen dem Piezoaktor und der Hülse in der Regel mit einer Vergussmasse gefüllt.

Da der Piezoaktor bei einer Betätigung zwar sehr hohe Kräfte ausüben kann, aber nur einen sehr geringen Leerlaufhub aufweist, kommt der Steifigkeit der Abstützung des Piezoaktors im Injektorkörper eine hohe Bedeutung für die Funktion der oben erwähnten Injektoren zu. Ist diese Verbindung zu weich, so führt der Piezoaktor bei der Betätigung zwar seinen Leerlaufhub aus, dieser wird aber dann durch elastische Verformung der Übertragungsglieder, insbesondere des Aktorfußes, kompensiert und die Längsdehnung des Piezoaktors bleibt weitgehend wirkungslos.

Aus diesem Grund ist üblicherweise der Aktorfuß als massives Metallteil mit hohen Anforderungen an die Genauigkeit der Kontaktflächen zum Piezoaktor und zum Injektorkörper ausgeführt. Da weiterhin in der Regel der Piezoaktor mit einer mechanischen Druckspannung innerhalb des Verbundes im Aktormodul permanent mit einer hohen Kraft vorgespannt ist, bilden der Piezoaktor, der Aktorfuß und der Injektorkörper funktional nahezu eine Einheit. Insbesondere bleiben durch die Vorspannung an den mechanischen Kontaktstellen zwischen den zuvor erwähnten Bauelementen diese stets kraftschlüssig miteinander verbunden.

Hierbei ist jedoch nachteilig, dass aufgrund dieser Bedingungen der Piezoaktor, der Aktorfuß und der Injektorkörper miteinander eine nur geringfügig gedämpfte, schwingfähige Anordnung darstellen. Dadurch schwingt diese Anordnung nach jeder Betätigung des Piezoaktors über einen längeren Zeitraum hinweg nach. Diese Schwingung kann sich dann über eine sogenannte Pratzung des Einspritz-Injektors auf den Zylinderkopf des Motors übertragen und führt letztendlich zu einem deutlich hörbaren Geräusch mit einem sehr hohen Frequenzspektrum im Bereich von mehreren Kilohertz, das akustisch im Allgemeinen als störend empfunden wird.

### Vorteile der Erfindung

Das eingangs beschriebene Aktormodul mit einem in einer Hülse angeordneten Piezoaktor weist in der Regel einen Mehrschichtaufbau von Piezolagen und dazwischen angeordneten Innenelektroden auf, die über eine wechselseitige seitliche Kontaktierung mit einer elektrischen Spannung beaufschlagt werden und wobei der Piezoaktor zwischen einem Aktorfuß und einem Aktorkopf eingefasst ist. Erfindungsgemäß ist in vorteilhafter Weise der Aktorfuß und/oder der Aktorkopf aus einem Sintermaterial hergestellt, beispielsweise nach der sogenannten "Metal Injektion Moulding" Methode (MIM).

Mit der Erfindung ist auf einfache Weise erreicht, dass störende Schaltgeräusche des Piezoaktors im Aktormodul weitgehend eliminiert werden können ohne die Funktion, beispielsweise eines Einspritz-Injektors als Anwendungsfall nachteilig zu beeinflussen. Es werden dabei keine zusätzlichen Bauelemente benötigt oder zusätzliche Kosten verursacht. Zwar würde lediglich eine Erhöhung der Elastizität des Aktorfußes ebenfalls dieses Geräusch dämpfen und in einen als angenehmer empfundenen Frequenzbereich verschieben, dies wäre aber für die Funktion des Injektors sehr abträglich.

Es ist weiterhin für die mechanischen Eigenschaften der erfindungsgemäßen Anordnung vorteilhaft, wenn das Sintermaterial nach dem Sintern zumindest an den Kontaktflächen zum Piezoaktor, zum Injektorkörper und/oder zum O-Ring gehärtet ist. Das Sintermaterial kann darüber hinaus auch auf einfache Weise nach dem Sintern zumindest an den Kontaktflächen zum Piezoaktor zum Injektorkörper und/oder zum O-Ring noch spanend bearbeitet werden.

Gemäß einer besonders vorteilhaften Ausführungsform der Erfindung weist der Aktorfuß zur weiteren Verbesserung des Dämpfungsverhaltens mindestens eine Durchgangsbohrung auf, wobei diese Durchgangsbohrungen bevorzugt auch räumlich schief oder windschief und/oder asymmetrisch angeordnet werden können.

Bei bisher üblichen Versuchen, die Dämpfung zu verbessern, wurde beispielsweise der Aktorfuß mit Längsbohrungen versehen. Dabei wird das Geräusch zwar ohne nennenswerte funktionale Nachteile deutlich abgeschwächt, allerdings ist eine zusätzliche Zwischenplatte zwischen dem Piezoaktor und dem Aktorfuß erforderlich und die zusätzliche Bearbeitung des Aktorfußes ist außerdem mit zusätzlichen Kosten verbunden.

### Zeichnung

Ein Ausführungsbeispiel des erfindungsgemäßen Aktormoduls wird anhand der Zeichnung erläutert. Es zeigen:
Figur 1 einen Schnitt durch ein Aktormodul mit einem Piezoaktor aus einem Mehrschichtaufbau von Lagen aus Piezokeramik und Elektroden in einem Anwendungsaufbau nach dem Stand der Technik,
Figur 2 eine Darstellung eines erfindungsgemäßen Aktorfußes aus einem Sintermaterial und
Figur 3a und 3b jeweils einen Schnitt durch eine Ausführung des Aktorfußes nach der Figur 2 ergänzt mit Durchgangsbohrungen.

### Beschreibung des Ausführungsbeispiels

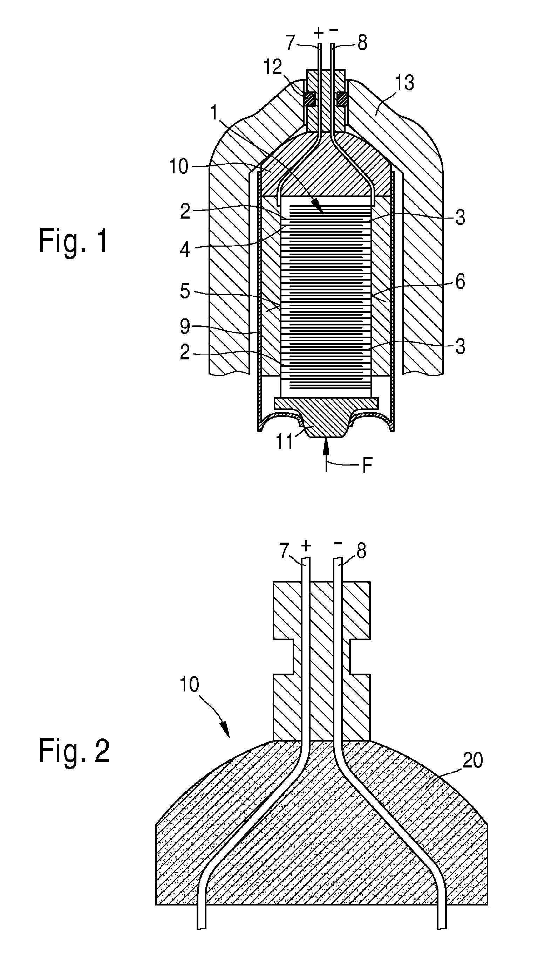

In Figur 1 ist ein Aktormodul mit einem Piezoaktor 1 nach dem Stand der Technik gezeigt, der in an sich bekannter Weise aus Piezofolien 2 eines Keramikmaterials mit einer geeigneten Kristallstruktur aufgebaut ist, so dass unter Ausnutzung des sogenannten Piezoeffekts beim Anlegen einer äußeren elektrischen Spannung an Innenelektroden 3 und 4 über Kontaktflächen 5 und 6 eine mechanische Reaktion des Piezoaktors 1 erfolgt. Die äußere Spannung wird über isolierte Zuleitungen 7 und 8 auf die Kontaktflächen 5 und 6 geführt. Bei einer Beaufschlagung des Piezoaktors 1 mit dieser Spannung kann eine Kraft F je nach Polarität als Zug oder Druck ausgeübt werden.

Ferner sind in der Figur 1 der in einer Hülse 9 des Aktormoduls gehaltene Aktorfuß 10 und der Aktorkopf 11 zu erkennen, die jeweils den Piezoaktor 1 in der Hülse 9 und darüber hinaus in der Betätigungsrichtung einfassen. Insbesondere der Aktorfuß 10 wird beim Stand der Technik üblicherweise spanend aus einem massiven Metallteil hergestellt. Das Aktormodul mit den zuvor beschriebenen Bauelementen ist gemäß der Figur 1 über einen isolierenden O-Ring 12 dicht in einem Injektorkörper 13 für einen hier nicht näher dargestellten, eingangs erwähnten Common-Rail-Injektor gehalten.

Aus Figur 2 ist eine erfindungsgemäße Abwandlung des Aktorfußes 10 nach der Figur 1 gezeigt, bei der der Aktorfuß 10 aus einem Sintermaterial 20 gebildet ist. Durch diese Materialauswahl erhöht sich die Schwingungs-Eigendämpfung der gesamten Anordnung aus dem Aktormodul und dem Injektor, wodurch das Geräusch, welches durch das Schalten des Piezoaktors 1 hervorgerufen wird, gedämpft wird ohne die Steifigkeit des Aktorfußes 10 zu reduzieren.

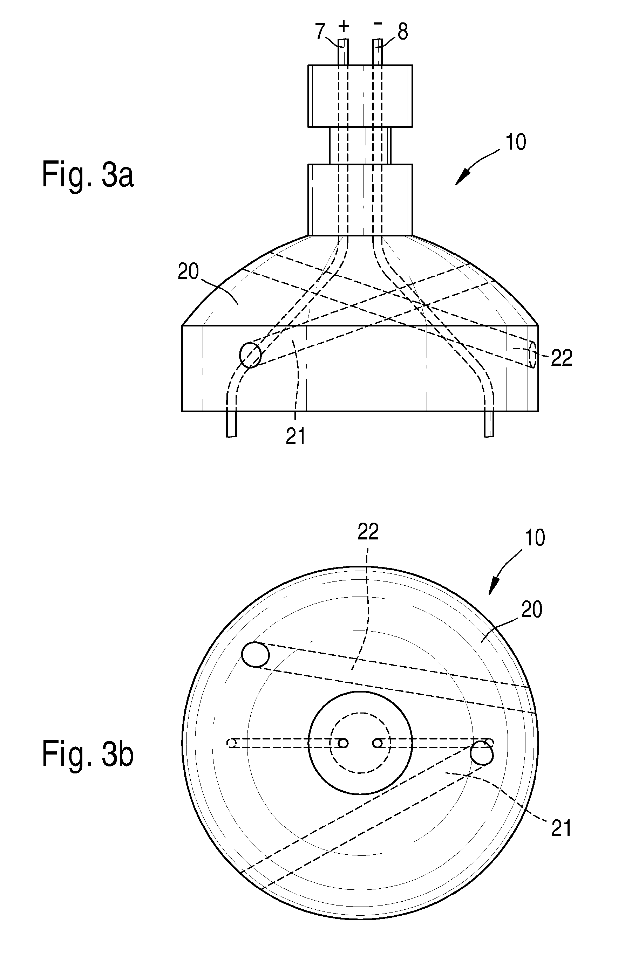

In Figur 3a ist ein Längsschnitt und in Figur 3b ist ein Querschnitt durch eine ergänzte Ausführung des Aktorfußes 10 als Sinterteil 20 nach der Figur 2 dargestellt. Hier sind räumlich windschief und/oder asymmetrisch angeordnete Bohrungen 21 und 22 als akustische Dämpfungskanäle in den Aktorfuß 10 eingebracht, womit sich eine weitere Verbesserung der Geräuschdämpfung im Aktormodul und somit in der gesamten Injektoranordnung erreichen lässt.

Der zuvor beschriebene Aktorfuß 10 mit dem Sintermaterial 20 lässt sich beispielsweise mit der an sich bekannten Methode des sogenannten Metal Injection Moulding (MIM) herstellen. Um die gewünschte Härte und Oberflächenqualität am Aktorfuß 10 am Ende zu erzielen, kann das so hergestellte Bauelement nach dem Sintern gehärtet und/oder gegebenenfalls auch an den Kontaktflächen zum Piezoaktor 1 zum Injektorkörper 13 und eventuell auch zum O-Ring 12 spanend bearbeitet werden.

## Patentansprüche

1. Aktormodul mit einem in einer Hülse (9) angeordneten Piezoaktor (1), wobei
- der Piezoaktor (1) zwischen einem Aktorfuß (10) und einem Aktorkopf (11) eingefasst ist, **dadurch gekennzeichnet, dass**
- der Aktorfuß (10) und/oder der Aktorkopf (11) aus einem Sintermaterial (20) hergestellt ist.

2. Aktormodul nach Anspruch 1, **dadurch gekennzeichnet,**
**dass**
- das Sintermaterial (20) nach der Metal Injektion Moulding Methode hergestellt ist.

3. Aktormodul nach Anspruch 1 oder 2, **dadurch gekennzeichnet, dass**
- das Sintermaterial (20) nach dem Sintern zumindest an den Kontaktflächen zum Piezoaktor (1), zum Injektorkörper (13) und/oder zum O-Ring (12) gehärtet ist.

4. Aktormodul nach einem der vorhergehenden Ansprüche,
**dadurch gekennzeichnet, dass**
- das Sintermaterial (20) nach dem Sintern zumindest an den Kontaktflächen zum Piezoaktor (1), zum Injektorkörper (13) und/oder zum O-Ring (12) spanend bearbeitet ist.

5. Aktormodul nach einem der vorhergehenden Ansprüche,
**dadurch gekennzeichnet, dass**
- der Aktorfuß (10) mindestens eine Durchgangsbohrung (21,22) aufweist.

6. Aktormodul nach Anspruch 5, **dadurch gekennzeichnet,**
**dass**
- die Durchgangsbohrungen (21,22) räumlich schief und/oder asymmetrisch angeordnet sind.

7. Aktormodul nach einem der vorhergehenden Ansprüche,
**dadurch gekennzeichnet, dass**
- das Aktormodul Bestandteil eines Common-Rail-Injektors für die Steuerung einer Einspritzdüse für die Zumessung von Kraftstoff in einem Verbrennungsmotor ist.
